(19) Europäisches Patentamt
European Patent Office
Office européen des brevets

(11) Publication number: **0 450 254 A1**

# (12) EUROPEAN PATENT APPLICATION

(21) Application number: **90810270.0**

(51) Int. Cl.5: **G03F 7/027**, G03C 9/08

(22) Date of filing: **03.04.90**

(43) Date of publication of application:
**09.10.91 Bulletin 91/41**

(84) Designated Contracting States:
**CH LI**

(71) Applicant: **CIBA-GEIGY AG**
**Klybeckstrasse 141**
**CH-4002 Basel(CH)**

(72) Inventor: **Hunziker, Max, Dr.**
**Chasseralstrasse 8**
**CH-3186 Düdingen(CH)**
Inventor: **Schulthess, Adrian, Dr.**
**Uf em Bärg**
**CH-1734 Tentlingen(CH)**
Inventor: **Hofmann, Manfred, Dr.**
**Route Bel-Air 38**
**CH-1723 Marly(CH)**

## (54) Photocurable compositions.

(57) The invention relates to a liquid resin composition which can be polymerized by radiation and which contains
(i) a difunctional monomeric or polymeric acrylate or methacrylate,
(ii) a tri- or polyfunctional acrylate or methacrylate,
(iii) at least one unsaturated monofunctional monomeric compound of the formula VI

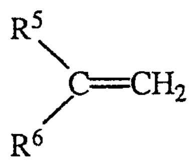

(VI),

wherein $R^5$ denotes hydrogen or methyl and $R^6$ is a group of the formula VII

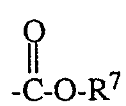

(VII),

$R^7$ being tetrahydrofurfuryl, cyclohexyl, 2-phenoxyethyl, benzyl, isobornyl, glycidyl, dicyclopentenyl, morpholinoethyl, dimethylaminoethyl, diethylaminoethyl or a $C_1$-$C_{20}$ linear or branched aliphatic residue, or - if $R^5$ is hydrogen $R^6$ denotes additionally pyrrolidinon-2-yl, imidazonyl, carbazolyl, anthracenyl, phenyl, $C_5$-$C_8$cycloalkyl, naphthenyl, 2-norbornyl, pyridyl, N-caprolactamyl or toluyl and
(iv) a photo-polymerization initiator for (i), (ii) and/or (iii), characterized in that said initiator is selected from the group consisting of
(a) anionic dye-iodonium ion compounds of the formula VIII

EP 0 450 254 A1

$$[R^8\text{-}I^{\oplus}\text{-}R^9]_m \; D^{m\ominus} \qquad \text{(VIII)}$$

where $D^{\ominus}$ is an anionic dye and $R^8$ and $R^9$ are independently selected from the group consisting of aromatic nuclei such as phenyl or naphthyl and m is 1 or 2;

(b) anionic dye-pyrrylium compounds of the formula IX

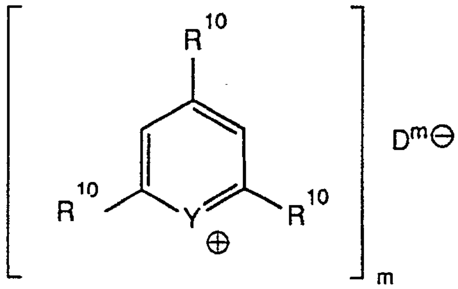

(IX)

where $D^{\ominus}$ and m are as defined above, $R^{10}$ denotes phenyl and Y denotes O or S;

(c) cationic dye-borate anion complexes of the formula X

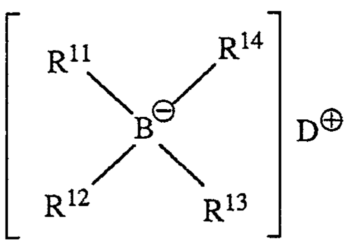

(X)

where $D^{\oplus}$ is a cationic dye; and $R^{11}$, $R^{12}$, $R^{13}$ and $R^{14}$ are independently selected from the group consisting of alkyl, aryl, alkaryl, aralkyl, alkenyl, alkinyl, alycyclic and saturated or unsaturated heterocyclic groups; and

(d) a dye-sensitized photopolymerizable composition comprising a photoreducible dye, a thiol and optionally a N,N-dialkylaniline.

Such compositions are suitable in the stereolithographic process.

The present invention relates to liquid resin compositions which are photosensitive, a process for polymerizing said compositions by means of actinic radiation and a process for generating three-dimensional objects from these liquid resin compositions.

It is known to utilize radiation-sensitive liquid resin compositions in many different fields of technology, e.g. in coatings, photoresists, relief printing forms and printing inks or adhesives. Typical examples and design considerations of light curable compositions containing acrylic or vinyl compounds and suitable photoinitiators are described in S.P. Pappas (Ed.), "UV Curing: Science and Technology" published by the Technology Marketing Corp., e.g. pp. 171-184(1978). In principle such liquid resin compositions are also suitable for the production of three-dimensional solid objects by the stereolithographic process as described in USP 4,575,330. However the typioal systems are appropriate materials for particular applications such as coatings or adhesives but are unsuitable in the stereolithographic process. Many are too viscous, others exhibit unacceptable shrinkage upon curing or insufficient photosensitivity for e.g. laser exposure at a given wavelength. Others produce objects with insufficient strength or exhibit poor layer-to-layer adhesion or brittleness after complete cure.

"Stereolithography" is a method for making solid objects by successively "printing" thin layers of a curable material. e.g. a UV curable material, one on top of the other. A programmed movable spot beam of UV light shining on a surface or layer of UV curable liquid is used to form a solid cross-section of the object at the surface of the liquid. The object is then moved, in a programmed manner, away from the liquid surface by the thickness of one layer, and the next cross-section is then formed and adhered to the immediately preceding layer defining the object. This process is continued until the entire object is formed.

Essentially all types of object forms can be created with the technique of stereolithography. Complex forms are more easily created by using the functions of a computer to help generate the programmed commands and to send the program signals to the stereolithographic object forming subsystem.

Of course, it will be appreciated that other forms of appropriate synergistic stimulation for a curable fluid medium, such as particle bombardment (electron beams and the like), chemical reactions by spraying materials through a mask or by ink jets, or impinging radiation other than ultraviolet or visible light, may be used in the practice of the stereolithographic process.

By way of example, in the practice of stereolithography, a body of a fluid medium capable of solidification in response to prescribed stimulation is first appropriately contained in any suitable vessel to define a designated working surface of the fluid medium at which successive cross-sectional laminae can be generated. Thereafter, an appropriate form of synergistic stimulation, such as a spot of UV or VIS light or the like, is applied as a graphic pattern at the specified working surface of the fluid medium to form thin, solid, individual layers at that surface, each layer representing an adjacent cross-section of the three-dimensional object to be produced. Superposition of successive adjacent layers on each other is automatically accomplished, as they are formed, to integrate the layers and define the desired three-dimensional object. In this regard, as the fluid medium cures and solid material forms as a thin lamina at the working surface, a suitable platform to which the first lamina is secured is moved away from the working surface in a programmed manner by any appropriate actuator, typically all under the control of a micro-computer or the like. In this way, the solid material that was initially formed at the working surface is moved away from that surface and new liquid flows into the working surface position. A position of this new liquid is, in turn, converted to solid material by the programmed UV or VIS light spot to define a new lamina, and this new lamina adhesively connects to the material adjacent to it, i.e., the immediately preceding lamina. This process continues until the entire three-dimensional object has been formed. The formed object is then removed from the container and the apparatus is ready to produce another object, either identical to the first object or an entirely new object generated by a computer or the like.

In the last few years different efforts have been made to develop systems which are specifically designed for the stereolithographic process. Kodama, Rev. Sci. Instrum. 52 (11) 1170-1173 (1981) discloses as the liquid photo-hardening polymer the commercial product "Tevista" which is a mixture of unsaturated polyester, acrylic ester, styrene monomer, polymerization initiator and sensitizer. The disadvantage of this system in the stereolithographic process resides in its insufficient photosensitivity and its very low green strength. US 4,575,330 describes the stereolithography process in detail - which is incorporated by reference into this disclosure - and as liquid medium a modified acrylate is reported which is a commercial product of Loctite Ltd. "Potting Compound 363". Such compositions are disclosed in US 4,100,141. This type of liquid resin compositions exhibit an insufficient photosensitivity which causes inacceptable build-up times for generating three-dimensional objects. A system which is actually used at present in stereolithography is "Desolite® SLR 800" (ex De Soto Inc.) This type of material containing various difunctional acrylates allows to generate small complex objects within a reasonable time. The drawbacks of this composition is its only mediocre photosensitivity, the very low green strength, the significant shrinkage

upon cure and the brittleness after complete cure.

It is evident that liquid resin compositions suitable in the stereolithographic process must fulfill various requirements placed on them. The difficulty is that the number of parameters is relatively high with the additional complexity that these parameters are not independent from each other in the sense that an improvement with respect to one parameter almost automatically results in a reduced performance in another property. The most important requirements, which a stereolithographic composition should fulfill, are:

(a) The viscosity must be adapted to the apparatus for the production of three-dimensional objects by stereolithography. For the levelling method known at the present time the preferred viscosity range is 500 to 8000 mPas at 30 °C.

(b) The new technology of stereolithography requires a new definition of photosensitivity describing the relationship between the incident energy and the penetration depth into the liquid photosensitive composition forming solidified portions in this way. This property is known as "working speed". A suitable stereolithographic composition should require minimal exposure energy and exhibit a high cure depth.

(c) In the process of sequential photopolymerization of thin layers usually none of these layers is fully cured. An incomplete cure involves many gains in that it strongly reduces shrinkage (and thus deformation and internal stresses) increases or in some cases even enables layer to layer adhesion and markedly reduces the build-up time. The not fully cured object is called "green part" and the elastic or tensile modulus is known as "green strength". The green part receives a postcure of some sort, usually a suitable irradition such as flood exposure to UV/VIS light e.g. of a mercury or xenon arc lamp. The green strength of a workpiece is a very important parameter, as objects with a low green strength may deform under their own weight when removed from the liquid resin composition or they may sag when heated.

(d) Another important factor in stereolithography is the shrinkage and stress related deformation occurring upon curing which is known as curl. A curl factor of 1 indicates that no deformation is detectable. Usually a composition exhibiting a high cure depth shows an increased curl factor up to 3 or even more. Acceptable curl factors are between 1 and 1.5.

(e) It is evident that the objects produced by the stereolithographic process must exhibit good mechanical properties such as tensile strength, impact resistance and elongation at break. Frequently such parts are subsequently treated by sand blasting, sanding, filing etc. or may be cut or drilled.

From the above it is obvious that the selection of the liquid resin composition is a critical issue. Accordingly it is the object of the present invention to provide improved photopolymerizable compositions, especially for the stereolithographic process exhibiting high green strength in conjunction with a low curl factor and a high working speed at the wavelength of exposure. In order to improve overall efficiency of the stereolithographic process and to increase throughput, it is desirable to use radiation sources having a wavelength of ≧ 400 nm. If the radiation source is a laser beam, the selection of a wavelength ≧ 400 nm (VIS) is particularly benificial since lasers operating in the VIS region of the spectrum show a higher efficiency and much higher lifetime than lasers operating in the UV. Thus VIS laser photons can be produced at lower cost. However, for this purpose special photoinitiators have to be used. Classes of such photoinitiators are known and are described e.g. in US 4,772,541; US 4,874,685 or US 4,772,530.

Accordingly, the present invention relates to liquid resin compositions which are photosensitive at greater than about 400 nm comprising

(i) at least one difunctional monomeric or oligomeric acrylate or methacrylate having a viscosity of more than 500 mPas at 25 °C,

(ii) at least one tri-, tetra- or pentacrylate or -methacrylate selected from the group consisting of the compounds of the formulae I, II and III

$$R^1\text{-}CH_2\text{-}C\text{-}(CH_2\text{-}R^2)_3$$ (I)

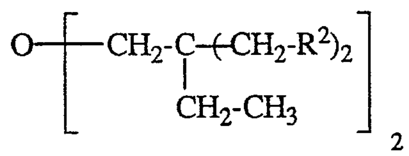

(II)

$$R^2\text{-}CH\text{-}(CH_2\text{-}R^2)_2$$ (III),

wherein $R^1$ denotes hydrogen, methyl, hydroxy or a group

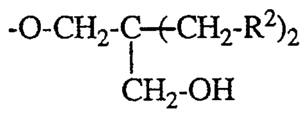

(IV)

and $R^2$ is a group

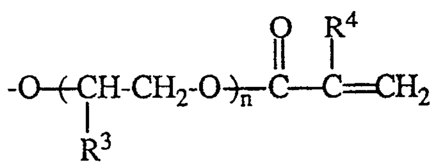

(V)

wherein n is an integer 0, 1, 2 or 3, $R^3$ and $R^4$ are each independently of the other hydrogen or methyl, (iii) at least one unsaturated monofunctional monomeric compound of the formula VI

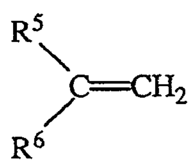

(VI),

wherein $R^5$ denotes hydrogen or methyl and $R^6$ is a group of the formula VII

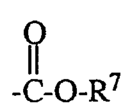

(VII),

$R^7$ being tetrahydrodurfuryl, cyclohexyl, 2-phenoxyethyl, benzyl, isobornyl, glycidyl, dicyclopentenyl, morpholinoethyl, dimethylaminoethyl, diethylaminoethyl or a $C_1$-$C_{20}$ linear or branched aliphatic residue, or - if $R^5$ is hydrogen $R^6$ denotes additionally pyrrolidinon-2-yl, imidazolyl, carbazolyl, anthracenyl, phenyl, $C_5$-$C_8$cycloalkyl, naphthenyl, 2-norbornyl, pyridyl, N-caprolactamyl or toluyl and

(iv) a photo-polymerization initiator for (i), (ii) and/or (iii), characterized in that said initiator is selected from the group consisting of

(a) anionic dye-iodonium ion compounds of the formula VIII

$$[R^8\text{-}I^{\oplus}\text{-}R^9]_m \; D^{m\ominus} \qquad \text{(VIII)}$$

where $D^{\ominus}$ is an anionic dye and $R^8$ and $R^9$ are independently selected from the group consisting of aromatic nuclei such as phenyl or naphthyl and m is 1 or 2;

(b) anionic dye-pyrrylium compounds of the formula IX

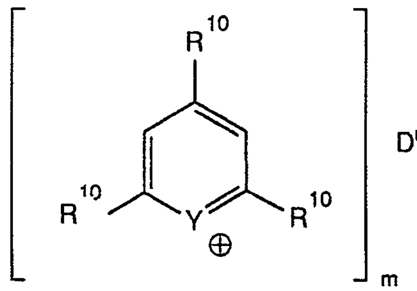

(IX)

where $D^{\ominus}$ and m are as defined above, $R^{10}$ denotes phenyl and Y is O or S;

(c) cationic dye-borate anion complexes of the formula X

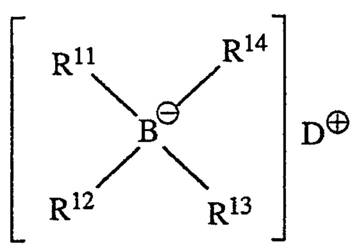

(X)

where $D^{\oplus}$ is a cationic dye; and $R^{11}$, $R^{12}$, $R^{13}$ and $R^{14}$ are independently selected from the group consisting of alkyl, aryl, alkaryl, aralkyl, alkenyl, alkinyl, alicyclic and saturated or unsaturated heterocyclic groups; and

(d) a mixture comprising a photoreducible dye, a thiol and optionally a N,N-dialkylaniline.

In a preferred embodiment of the instant invention component (i) contains an acrylic or methacrylic diester of the general formula XI

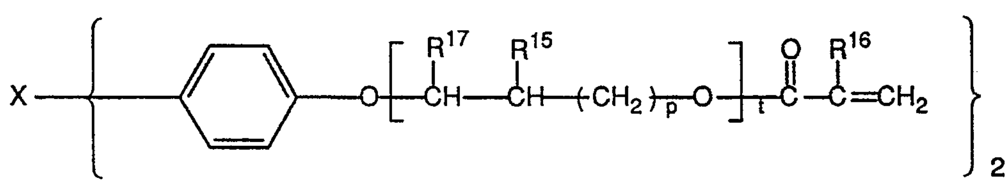

(XI)

wherein p is 0 or 1 and t is 0 or 1 and if p is 0, t can also be 2 or 3, X denotes -O-,-S-, $-SO_2-$ or $-C(R^{18})-(R^{19})-$, $R^{18}$ and $R^{19}$ each being independently of the other hydrogen, $-CF_3$ or methyl and $R^{17}$ denotes hydrogen if p is 1 and hydrogen or methyl if p is 0, and $R^{15}$ denotes hydroxy if p is 1 and hydrogen if p is 0, and $R^{16}$ is hydrogen or methyl.

Most preferably component (i) contains at least one compound of the formula XI, wherein p is 1, particularly the bisphenol-A-type materials, wherein X denotes $-C(CH_3)_2-$. Such compounds are known, e.g. from US 3,661,576. These compounds can be produced by reacting the corresponding diglycidylethers with acrylic or methacrylic acid and thus contain usually a certain amount of oligomeric materials. If the viscosity of these mixtures is too high the desired viscosity can be adjusted with the components (ii) and/or (iii) having a low viscosity.

The compounds of the formula XI, wherein p is 0 are also known, e.g. from GB 1,263,541 and are usually prepared by a transesterification reaction of the corresponding diols with the methylester of acrylic or methacrylic acid.

In a further preferred embodiment of the instant invention a mixture of compounds of the formula XI is used, e.g. at least one compound wherein p is 1 and at least one compound wherein p is 0. The ratio between these compounds is not critical, in preferred mixtures the amount of the p = 1-compound is >50 % per weight based on the total weight of the component (i).

Depending on the desired properties of the liquid resin composition and the crosslinked polymer the component (i) is present in a total amount of about 10 to about 80 weight percent based on the total composition, preferably 25 to about 80 weight percent.

If compounds of the formula XI, wherein p is 1 are used, they are present in a total amount of about 30 to about 60 weight percent based on the total liquid resin composition.

Amongst the compounds of the formula I, II and III those of the formula I wherein $R^1$ is methyl or a group of the formula IV and $R^2$ denotes a group of the formula V wherein n is 0 are particularly preferred.

Especially preferred are trimethylolpropanetrimethacrylate and dipentaerythritolpentaacrylate. Beside these two a large number of tri- or multifunctional monomeric acrylates or methacrylates are known by those skilled in the art. e.g. pentaerythritoltetraacrylate, glyceroltriacrylate or the triacrylate of tris-(hydroxyethyl)-isocyanurate. Many of these compounds are also commercially available also as alkoxylated derivatives. Preferably the component (ii) is present in an amount of about 5 to about 25 weight percent of the total composition. Amounts below this range produce compositions with low rigidity and low green strength. Higher amounts cause higher shrinkage.

Also the monofunctional monomeric compounds of the formula VI are well known compounds many of which are commercially available. Most of them have a low viscosity which allows to adjust the viscosity of the whole system. Examples of such compounds are 1-vinylpyrrolidone, isobornylacrylate and/or phenoxyethylacrylate. Generally compounds of the formula VI having relatively bulky substituents are especially suitable. The residue $R^5$ in formula VI preferably denotes a group of the formula VII. If $R^7$ is a $C_1$-$C_{20}$ linear or branched aliphatic residue it denotes preferably a bulky $C_3$-$C_{12}$alkyl substituent. The most preferred compounds of the formula VI are those which have a boiling point above 140 °C and particularly those of the formula VI wherein $R^5$ is hydrogen and $R^6$ is a group of the formula VII, pyrrolidon-2-yl or N-caprolactamyl.

In preferred compositions the component (iii) is present in an amount of about 1 to about 25, and most perferably in an amount of about 5 to about 25 weight percent based on the total composition.

The photoinitiators (iv) generating free radicals when subjected to radiation are known compounds. The absorption characteristics must match the spectral features of the radiation source.

Typical photoinitiators of type (a) and (b) are described in US 4,772,530 in col. 11 to 13. The disclosure thereof is incorporated by reference into this application. Representative examples of anionic dyes include xanthene and oxonol dyes. For example Rose Bengal, eosin, erythiosin, and fluorescein dyes are useful.

Photoinitiators of type (c) are known from US 3,567,453; 4,307,182; 4,343,891; 4,447,521; 4,450,227 and especially 4,772,530 in col. 5 to 10. The disclosure of the latter is incorporated by reference into this application. Specific examples of useful cationic dyes are Methylene Blue, Safranine O, Malachite Green, cyanine dyes or rhodamine dyes. The definitions of the groups $R^{11}$, $R^{12}$, $R^{13}$ and $R^{14}$ is discussed in detail in US 4,772,530 in col. 6.

Photoinitiators of type (d) are described in US 4,874,685 in col. 2 to 4. The disclosure thereof is incorporated by reference into this application. Photoreducible dyes are well known and include photoreducible methine, polymethine, triarylmethane, indoline, thiazine, acridine, xanthane, oxazine and acridine dyes. Thiols useful in the instant invention can be represented by the general formula XII

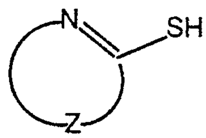

(XII)

where Z represents the atoms necessary to complete a 4 to 10 membered monocyclic or bicyclic heterocyclic ring, such as a benzoxazole, benzimidazole, benzthiazole, tetrazole, etc. While the dye and the thiol can be used alone as the photoinitiator system it is preferred to add a N,N-dialkylaniline as antoxidizer. Representative examples of such antoxidizers are given in US 4,874,685 in col. 3 and 4.

The photoinitiators of type (c), i.e. the cationic dye-borate anion complexes of the formula X are most preferred.

The photoinitiators are known to be added in an effective amount within the range of about 0.1 to about 10 weight percent based on the total composition. If the instant compositions are used in the stereolithographic process normally using a laser light source it is essential that the absorbance of the composition is adjusted by the type and concentration of the initiator to a level allowing a cure depth at practical laser drawing speed of approximately 0.1 to 1.0 mm.

If desired the compositions of the instant invention can optionally contain further customary additives, such as stabilisers and/or polymerization inhibitors, air release agents, wetting and levelling agents, sensitizers and photoactivators, oxygen scavengers, antisettling agents, dyes, pigments or fillers e.g. plastic beads.

The compositions according to this invention can be produced in a known manner, e.g. by a premixing of the individual constituents and the subsequent combining thereof, or by mixing together the individual components in devices normally used for the purpose, such as stirrer vessels, which ensure a uniform mixing, in the absence of light and e.g. at slightly elevated temperatures.

The instant compositions are photosensitive. Suitable radiation sources are useful, having wavelengths within the range of 400-650 nm. Particularly useful is laser light from HeCd, HeNe, argon-ion, metal vapour and frequency multiplied NdYAG lasers. It is known by the skilled persons that for each chosen light source the appropriate initiator(s) has to be adapted and/or sensitized. However it has to be recognized that the penetration depth and the working speed directly depend on the absorption coefficient and the concentration of the photoinitiator(s). In stereolithography preferred initiators are those allowing the highest penetration depth combined with the highest number of generated initiating free radicals per energy unit.

The instant compositions are liquids with viscosities in the range of several hundred to thousand mPas at 30 °C, preferably 200 to 8000 mPas, most preferably 500 to 4000 mPas. One of the unexpected feature of these compositions is their high photosensitivity in combination with low curl and high green strength. This excellent combination of properties, being especially important in the stereolithographic process, is not found in known resin systems. A further characteristic of the new photopolymer systems of this invention is their high strength and toughness after complete cure.

Accordingly the instant invention further relates to a method of generating three-dimensional objects from a fluid medium capable of altering its physical state when subjected to prescribed radiation, said method comprising:

- containing as fluid medium a body of a composition according to claim 1;
- irradiating a designated surface of said composition with a prescribed pattern to provide a thin cross-sectional lamina at said designated surface; and
- repeatedly forming a series of such laminae in succession to build the desired three-dimensional object from successive adjacent laminae which together define said object.

The radiation source used in this method is preferably a laser beam which is most preferably computer controlled.

<u>Example 1</u>: 50 grams of a diacrylate ester of bisphenol A type epoxy resin with a viscosity of 2300 mPas at 65 °C and a theoretical functionality of 2 was mixed with 50 grams of ethoxylated bisphenol A diacrylate and 0.2 grams of cyanine borate photoinitiator with an absorption maximum at 548 nm. The mixture was then exposed with a focused beam of an Argon ion laser emitting at 514 nm at a power level of 250 mW and travelling at a speed of 142 mm/S over the resin surface. The string of solid cured plastic had a height of 0.5 mm. This corresponds to a photosensitivity of approximately 500 mJ/$cm^2$.

<u>Example 2</u>: The experiment of example 1 was repeated, however, the initiator content was increased to 0.4 grams and the wavelength of exposure was 488 nm. The string of solid cured plastic had a height of

0.25 mm, translating into a photosensitivity of approximately 160 $mJ/cm^2$.

## Claims

1. Liquid resin compositions which are photosensitive at greater than about 400 nm comprising
   (i) at least one difunctional monomeric or oligomeric acrylate or methacrylate having a viscosity of more than 500 mPas at 25 ° C,
   (ii) at least one tri-, tetra- or pentaacrylate or -methacrylate selected from the group consisting of the compounds of the formulae I, II and III

$$R^1\text{-}CH_2\text{-}C\text{-}(CH_2\text{-}R^2)_3 \qquad (I)$$

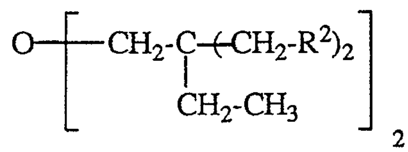

(II)

$$R^2\text{-}CH\text{-}(CH_2\text{-}R^2)_2 \qquad (III),$$

wherein $R^1$ denotes hydrogen, methyl, hydroxy or a group

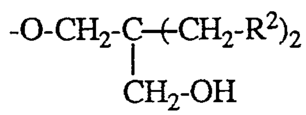

(IV)

and $R^2$ is a group

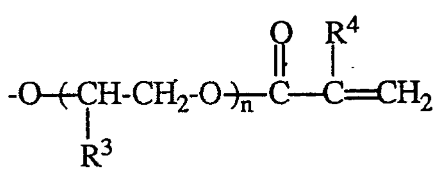

(V)

wherein n is an integer 0, 1, 2 or 3, $R^3$ and $R^4$ are each independently of the other hydrogen or methyl,
(iii) at least one unsaturated monofunctional monomeric compound of the formula VI

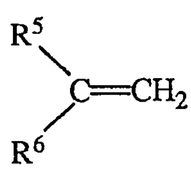

(VI),

wherein $R^5$ denotes hydrogen or methyl and $R^6$ is a group of the formula VII

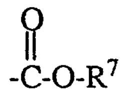

(VII),

$R^7$ being tetrahydrodurfuryl, cyclohexyl, 2-phenoxyethyl, benzyl, isobornyl, glycidyl, dicyclopentenyl, morpholinoethyl, dimethylaminoethyl, diethylaminoethyl or a $C_1$-$C_{20}$ linear or branched aliphatic residue, or - if $R^5$ is hydrogen $R^6$ denotes additionally pyrrolidinon-2-yl, imidazolyl, carbazolyl, anthracenyl, phenyl, $C_5$-$C_8$cycloalkyl, naphthenyl, 2-norbornyl, pyridyl, N-caprolactamyl or toluyl and
(iv) a photo-polymerization initiator for (i), (ii) and/or (iii), characterized in that said initiator is selected from the group consisting of

(a) anionic dye-iodonium ion compounds of the formula VIII

$$[R^8\text{-}I^{\oplus}\text{-}R^9]_m \; D^{m\ominus} \qquad \text{(VIII)}$$

where $D^{\ominus}$ is an anionic dye and $R^8$ and $R^9$ are independently selected from the group consisting of aromatic nuclei such as phenyl or naphthyl and m is 1 or 2;

(b) anionic dye-pyrrylium compounds of the formula IX

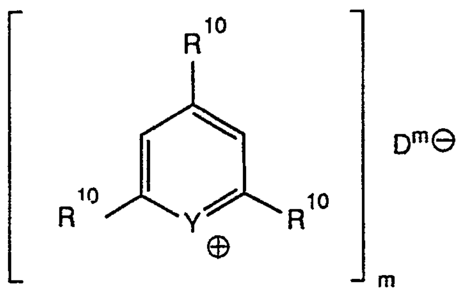

(IX)

where $D^{\ominus}$ and m are as defined above, $R^{10}$ denotes phenyl and Y denotes O or S;

(c) cationic dye-borate anion complexes of the formula X

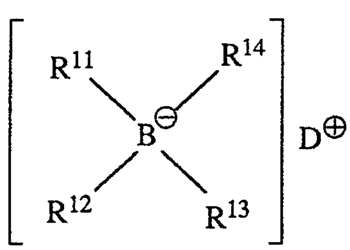

(X)

where $D^{\oplus}$ is a cationic dye; and $R^{11}$, $R^{12}$, $R^{13}$ and $R^{14}$ are independently selected from the group consisting of alkyl, aryl, alkaryl, aralkyl, alkenyl, alkinyl, alycyclic and saturated or unsaturated heterocyclic groups; and

(d) a mixture comprising a photoreducible dye, a thiol and optionally a N,N-dialkylaniline.

**2.** Composition according to claim 1 containing as component (i) at least one acrylic or methacrylic diester of the general formula XI

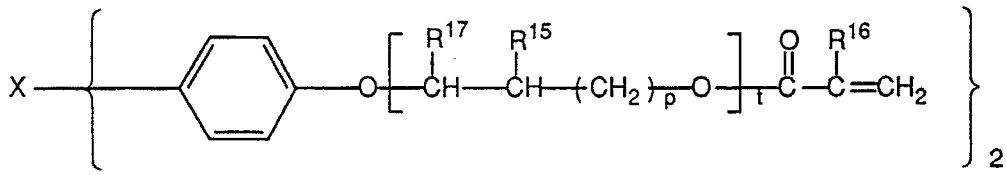

(XI)

wherein p is 0 or 1 and t is 0 or 1 and if p is 0, t can also be 2 or 3, X denotes -O-,-S-, $-SO_2-$ or $-C(R^{18})(R^{19})-$, $R^{18}$ and $R^{19}$ each being independently of the other hydrogen, $-CF_3$ or methyl and $R^{17}$ denotes hydrogen if p is 1 and hydrogen or methyl if p is 0, and $R^{15}$ denotes hydroxy if p is 1 and hydrogen if p is 0, and $R^{16}$ is hydrogen or methyl.

**3.** Compositions according to claim 2, characterized in that in formula XI p denotes 1.

**4.** Compositions according to claim 3, characterized in that in formula XI X is $-C(CH_3)_2-$.

**5.** Compositions according to claim 2 containing as component (i) a mixture of compounds of the formula XI comprising at least one compound wherein p is 1 and at least one compound wherein p is 0.

**6.** Compositions according to claim 1 containing the component (i) in a total amount of about 10 to about 80 weight percent of the total composition.

**7.** Compositions according to claim 3 containing the compound of formula XI in a total amount of 30 to about 60 weight percent based on the total composition.

**8.** Composition according to claim 1 containing as component (ii) at least one triacrylate or -methacrylate of the formula I wherein $R^1$ is methyl or a group of the formula IV and $R^2$ denotes a group of the formula V wherein n is 0.

**9.** Compositions according to claim 1 containing as component (ii) trimethylolpropanetrimethacrylate or dipentaerythritolpentaacrylate.

**10.** Composition according to claim 1 containing the component (ii) in a total amount of about 5 to about 25 weight percent based on the total composition.

**11.** Composition according to claim 1, containing as component (iii) a compound of the formula VI wherein $R^5$ is hydrogen and $R^6$ is a group of the formula VII, pyrrolidon-2-yl or N-caprolactamyl.

**12.** Compositions according to claim 11, containing as component (iii) 1-vinylpyrrolidone, isobornylacrylate and/or phenoxyethylacrylate.

**13.** Compositions according to claim 1, containing the component (iii) in a total amount of about 1 to about 25 weight percent based on the total composition.

**14.** Compositions according to claim 1, containing as component (iv) a photoinitiator (b).

**15.** Compositions according to claim 1, containing as component (iv) in a total amount of about 0.1 to about 10 weight percent based on the total composition.

**16.** Compositions according to claim 1 with a viscosity in the range of 500 to 4000 mPas at 30 °C.

**17.** A process for polymerizing the compositions according to claim 1 comprising subjecting said compositions to radiation having a wavelength of greater than about 400 nm.

**18.** A method of generating three-dimensional objects from a fluid medium capable of altering its physical state when subjected to prescribed radiation having a wavelength of greater than about 400 nm, said

method comprising:

- containing as fluid medium a body of a composition according to claim 1;
- irradiating a designated surface of said composition with a prescribed pattern to provide a thin cross-sectional lamina at said designated surface; and
- repeatedly forming a series of such laminae in succession to build the desired three-dimensional object from successive adjacent laminae which together define said object.

**19.** A method according to claim 18 wherein the radiation source is a laser beam.

**20.** A method according to claim 19 wherein the laser beam is computer controlled.

European
Patent Office

# EUROPEAN SEARCH REPORT

Application Number

**EP 90 81 0270**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 789 620 (I. SASAKI ET AL.)<br>* column 3, lines 66 - 68 * * column 4, lines 1 - 4 @ column 5, line 53 @ column 19, line 7 *<br>– – – | 1-17 | G 03 F 7/027<br>G 03 C 9/08 |
| Y,D | EP-A-0 223 587 (THE MEAD CORPORATION)<br>* page 3, lines 46 - 47 * * page 4, lines 10 - 12 *<br>– – – | 1-17 | |
| A,D | EP-A-0 171 069 (UVP)<br>* claim 34 *<br>– – – – – | 18-20 | |
| | | | **TECHNICAL FIELDS SEARCHED (Int. Cl.5)** |
| | | | G 03 F<br>G 03 C |

The present search report has been drawn up for all claims

| Place of search | Date of completion of search | Examiner |
|---|---|---|
| The Hague | 13 December 90 | DUPART J-M.B. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document